# FASCICULE DE BREVET EUROPEEN

(11) **EP 2 761 053 B1**
(45) Date de publication et mention de la délivrance du brevet: **07.03.2018**
(21) Numéro de dépôt: 12773044.8
(22) Date de dépôt: 14.09.2012
(51) Int. Cl.: C23C 16/04

(54) **DISPOSITIF DE CHARGEMENT POUR LA DENSIFICATION PAR INFILTRATION CHIMIQUE EN PHASE VAPEUR EN FLUX DIRIGE DE SUBSTRATS POREUX DE FORME TRIDIMENTIONNELLE**
LADEVORRICHTUNG ZUR VERDICHTUNG MITTELS CHEMISCHER INFILTRATION IN DER DAMPF PHASE IN GERICHTETER STRÖMUNG VON DREIDIMENSIONALEN PORÖSEN SUBSTRATEN
LOADING DEVICE FOR DENSIFICATION VIA CHEMICAL INFILTRATION IN STEAM PHASE IN DIRECTED FLOW OF THREE-DIMENSIONAL POROUS SUBSTRATES

(30) Priorité: 28.09.2011 FR 1158673
(43) Date de publication de la demande: 06.08.2014
(73) Titulaire: Safran Ceramics, 33185 Le Haillan (FR)
(72) Inventeur: BERTRAND, Sébastien, F-33480 Moulis En Medoc (FR); LAMOUROUX, Franck, F-33320 Le Taillan (FR); GOUJARD, Stéphane, F-33700 Merignac (FR)
(74) Mandataire: Desormiere, Pierre-Louis
(86) Numéro de dépôt international: PCT/FR2012/052066
(87) Numéro de publication internationale: WO 2013/045788

(56) Documents cités:
- WO-A1-2006/087495

## Description

### Arrière-plan de l'invention

La présente invention concerne les techniques d'infiltration chimique en phase vapeur utilisées notamment lors de la réalisation de pièces en matériau composite thermostructural. Elle concerne plus particulièrement la densification par dépôt de matrice de substrats poreux de forme complexe tridimensionnelle tels que des préformes fibreuses destinées à la fabrication d'aubes de moteurs aéronautiques.

Pour la fabrication de pièces en matériau composite, en particulier de pièces en matériau composite thermostructural constituées d'une préforme fibreuse réfractaire (fibres carbone ou céramique, par exemple) densifiée par une matrice réfractaire (carbone et/ou céramique, par exemple), il est courant de faire appel à des procédés d'infiltration chimique en phase vapeur. Des exemples de telles pièces sont des tuyères de propulseurs en composite carbone-carbone (C-C), des disques de freins, notamment de freins d'avions, en composites C-C, ou des aubes en composites à matrice céramique (CMC).

La densification de substrats poreux par infiltration chimique en phase vapeur consiste à placer les substrats dans une chambre de réaction d'une installation d'infiltration au moyen d'un outillage de support et à admettre dans la chambre un gaz réactif dont un ou plusieurs constituants sont des précurseurs du matériau à déposer au sein des substrats afin d'assurer leur densification. Les conditions d'infiltration, notamment composition et débit du gaz réactif, et température et pression dans la chambre sont choisies pour permettre une diffusion du gaz au sein de la porosité interne accessible des substrats afin qu'y soit déposé le matériau désiré par décomposition d'un constituant du gaz ou réaction entre plusieurs constituants de celui-ci. Le préchauffage du gaz réactif est habituellement réalisé par passage du gaz à travers une zone de préchauffage située dans la chambre de réaction et dans laquelle s'ouvre l'entrée du gaz réactif. Ce procédé correspond au procédé d'infiltration chimique en phase vapeur à flux libre.

Dans une installation industrielle d'infiltration chimique en phase vapeur, il est habituel de charger la chambre de réaction avec plusieurs substrats ou préformes à densifier simultanément pour augmenter le rendement du procédé de densification et, par conséquent, le taux de chargement des chambres de réaction.

Des procédés et installations de densification de substrats annulaires poreux par infiltration chimique en phase vapeur sont notamment décrits dans les documents US 2004 237898 et US 5 904 957. Cependant, ces procédés s'appliquent essentiellement à la densification de substrats de forme annulaire disposés en piles et ne sont pas adaptés pour la densification de substrats présentant des formes non axisymétriques.

Le document US 2008/0152803 décrit l'utilisation d'un outillage de chargement comprenant un conduit tubulaire disposé entre des premier et second plateaux et autour duquel sont disposés radialement des substrats minces en forme de plaque à densifier. L'outillage ainsi chargé est alors disposé à l'intérieur d'une chambre de réaction d'un four d'infiltration dont l'entrée d'admission en gaz réactif est raccordée au conduit tubulaire pour permettre l'admission d'un gaz réactif dans le conduit qui distribue le gaz le long des faces principales des substrats suivant une direction d'écoulement essentiellement radiale.

Toutefois, cet outillage de chargement reste limité à la densification en flux dirigé de substrats minces de forme simples tels que des fines plaques rectangulaires et ne peut permettre une densification homogène de substrats poreux présentant des formes complexes tridimensionnelles tels que des préformes fibreuses d'aubes. En effet, l'écoulement d'un flux gazeux sur des substrats de forme complexe tridimensionnelle est plus difficile à contrôler. Le manque de maîtrise de l'écoulement du gaz réactif sur l'ensemble des substrats à densifier entraîne l'apparition de gradients de densification dans les substrats. Or, l'uniformité de la densification d'un substrat conditionne les performances mécaniques de la pièce obtenue.

### Objet et résumé de l'invention

L'invention a pour but de fournir une solution de chargement qui permet de densifier des substrats poreux, en particulier de forme tridimensionnelle complexe s'étendant principalement dans une direction longitudinale minces, avec une capacité de chargement élevée, et ce en minimisant les gradients de densification dans les substrats.

Ce but est atteint avec un dispositif de chargement comprenant :
au moins un étage de chargement annulaire formé par des première et deuxième enceintes verticales annulaires disposées concentriquement l'une par rapport à l'autre et délimitant entre elles un espace de chargement annulaire pour les substrats poreux à densifier,
des premier et deuxième plateaux couvrant respectivement la partie inférieure et la partie supérieure de l'espace de chargement annulaire,
les première et deuxième enceintes verticales annulaires comprenant chacune des éléments de support répartis dans l'espace de chargement annulaire, les éléments de support des première et deuxième enceintes verticales annulaires étant radialement alignés de manière à définir entre eux des cellules de chargement unitaire destinées à recevoir chacune un substrat à densifier,
le dispositif comprenant en outre au moins un orifice d'alimentation en gaz et un orifice d'évacuation de gaz au voisinage de chaque cellule de chargement unitaire.

Le dispositif de chargement de l'invention permet à la fois d'optimiser le nombre de substrats qui peuvent être densifiés simultanément dans une même installation tout en contrôlant la direction d'écoulement du gaz réactif au niveau de chaque substrat et d'obtenir ainsi une densification uniforme de ces derniers. Une telle densification en série ne peut être obtenue avec des substrats aussi proches les uns des autres lorsque la flux n'est pas dirigé.

Le procédé selon l'invention permet, par conséquent, de réaliser la densification de substrats poreux minces, et ce en augmentant la qualité des pièces obtenues ainsi que le volume de chargement de la chambre de réaction.

En effet, une fois disposé dans une chambre de réaction, le dispositif de chargement de l'invention agit comme un miniréacteur dans lequel l'écoulement du gaz est maîtrisé. Avec ce dispositif, le chargement des substrats peut être préparé à l'avance en dehors des installations de densification et transporté facilement sans risque jusque dans la chambre de réaction. Ainsi, les temps de chargement/déchargement des chambres de réaction sont réduits.

Selon un mode réalisation du dispositif de l'invention, la première enceinte verticale annulaire de chaque étage de chargement comporte au moins un orifice d'alimentation en gaz au voisinage de chaque cellule de chargement unitaire tandis que la deuxième enceinte verticale annulaire de chaque étage de chargement comporte au moins un orifice d'évacuation de gaz au voisinage de chaque cellule de chargement unitaire.

Selon un aspect de l'invention, le dispositif de chargement comprend plusieurs étages de chargement annulaires empilés les uns sur les autres et disposés entre les premier et deuxième plateaux.

Selon un autre mode de réalisation du dispositif de l'invention, le premier plateau comporte des orifices d'alimentation en gaz au niveau de chaque cellule de chargement unitaire tandis que le deuxième plateau comporte des orifices d'évacuation de gaz au niveau de chaque cellule de chargement unitaire.

Selon un aspect de l'invention, le dispositif de chargement comprend plusieurs étages de chargement annulaires empilés les uns sur les autres et disposés entre les premier et deuxième plateaux.

Selon un autre aspect de l'invention, le dispositif de chargement comprend en outre plusieurs étages de chargement annulaires ayant des dimensions radiales différentes, lesdits étages étant disposés concentriquement les uns par rapport aux autres.

L'invention concerne également une installation de densification par infiltration chimique en phase vapeur de substrats poreux de forme tridimensionnelle s'étendant principalement dans une direction longitudinale, comportant une chambre de réaction, une conduite d'admission de gaz réactif située à une première extrémité de la chambre, et une conduite d'évacuation située au voisinage d'une seconde extrémité de la chambre opposée à la première,
caractérisée en ce que la chambre comprend une pluralité de substrats poreux de forme tridimensionnelle s'étendant principalement dans une direction longitudinale, lesdits substrats étant disposés dans un dispositif de chargement comprenant plusieurs étages de chargement selon l'invention, le ou les orifices d'alimentation en gaz dudit dispositif étant alimentés en gaz réactif par la conduite d'admission de gaz réactif de la chambre.

L'invention concerne encore une installation de densification par infiltration chimique en phase vapeur de substrats poreux de forme tridimensionnelle s'étendant principalement dans une direction longitudinale, comportant une chambre de réaction, une pluralité de conduites d'admission de gaz réactif situées à une première extrémité de la chambre, et au moins une conduite d'évacuation située au voisinage d'une seconde extrémité de la chambre opposée à la première,
caractérisée en ce que la chambre comprend une pluralité de substrats poreux de forme tridimensionnelle s'étendant principalement dans une direction longitudinale, lesdits substrats étant disposés dans une un ou plusieurs dispositifs de chargement comprenant chacun plusieurs étages de chargement annulaires empilés et/ou disposés concentriquement les uns par rapport autres et dont les orifices d'alimentation et d'évacuation de gaz sont formés respectivement sur les premier et deuxième plateaux, le ou les orifices d'alimentation en gaz de chaque dispositif étant alimentés en gaz réactif par les conduites d'admission de gaz réactif de la chambre.

Les dispositifs de chargement peuvent notamment être de même diamètre et disposés de façon juxtaposées dans la chambre de réaction ou être de diamètre décroissant et empilés les uns sur les autres suivant une structure pyramidale.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels:
- les figures 1 et 2 sont des vues en perspective d'un dispositif de chargement conformément à un mode de réalisation de l'invention ;
- la figure 3 est une vue en coupe partielle montrant le dispositif des figures 1 et 2 lors de la densification de substrats poreux ;
- la figure 4 est une vue en perspective d'un dispositif de chargement conformément à un autre mode de réalisation de l'invention ;
- la figure 5 est une vue en coupe partielle montrant le dispositif de la figure 4 lors de la densification de substrats poreux ;
- la figure 6 est une vue en perspective d'un dispositif de chargement comprenant plusieurs étages de chargement empilés conformément à un autre mode de réalisation de l'invention ;
- la figure 7 est une vue en coupe partielle montrant le dispositif de la figure 6 lors de la densification de substrats poreux ;
- la figure 8 est une vue en perspective d'un dispositif de chargement comprenant plusieurs étages de chargement empilés conformément à un autre mode de réalisation de l'invention ;
- la figure 9 est une vue en coupe partielle montrant le dispositif de la figure 8 lors de la densification de substrats poreux ;
- la figure 10 est une vue en perspective d'un dispositif de chargement comprenant plusieurs étages de chargement concentriques conformément à un autre mode de réalisation de l'invention ;
- la figure 11 est une vue en perspective d'un dispositif de chargement comprenant plusieurs étages de chargement concentriques et empilés conformément à un autre mode de réalisation de l'invention ;
- la figure 12 est une vue schématique en coupe montrant une installation de densification par infiltration chimique en phase vapeur dans laquelle des substrats sont chargés au moyen d'un dispositif de chargement comprenant plusieurs étages de chargement empilés du type de la figure 6 selon l'invention ;
- la figure 13 est une vue schématique en coupe montrant une installation de densification par infiltration chimique en phase vapeur dans laquelle des substrats sont chargés au moyen d'un dispositif de chargement comprenant plusieurs étages de chargement empilés du type de la figure 8 selon l'invention ;
- la figure 14 est une vue schématique en coupe montrant un agencement pyramidale de plusieurs dispositifs de chargement comprenant plusieurs étages de chargement empilés dans une installation de densification par infiltration chimique en phase vapeur selon l'invention ;
- la figure 15 est une vue schématique en coupe montrant un agencement par superposition de plusieurs dispositifs de chargement comprenant plusieurs étages de chargement empilés dans une installation de densification par infiltration chimique en phase vapeur selon l'invention.

### Description détaillée de mode de réalisation

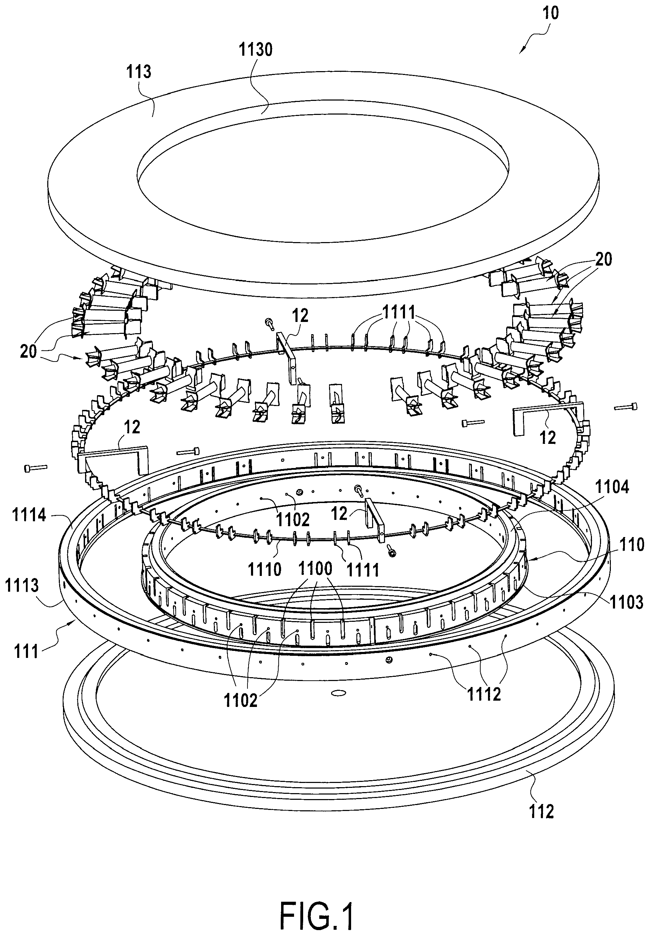

Les figures 1 à 3 représentent un dispositif ou outillage de chargement 10 qui, une fois chargée de substrats à densifier, est destiné à être introduite dans une chambre de réaction d'une installation industrielle d'infiltration chimique en phase vapeur. Dans l'exemple décrit ici, l'outillage 10 est destiné à recevoir des préformes fibreuses d'aube 20 de moteurs aéronautiques.

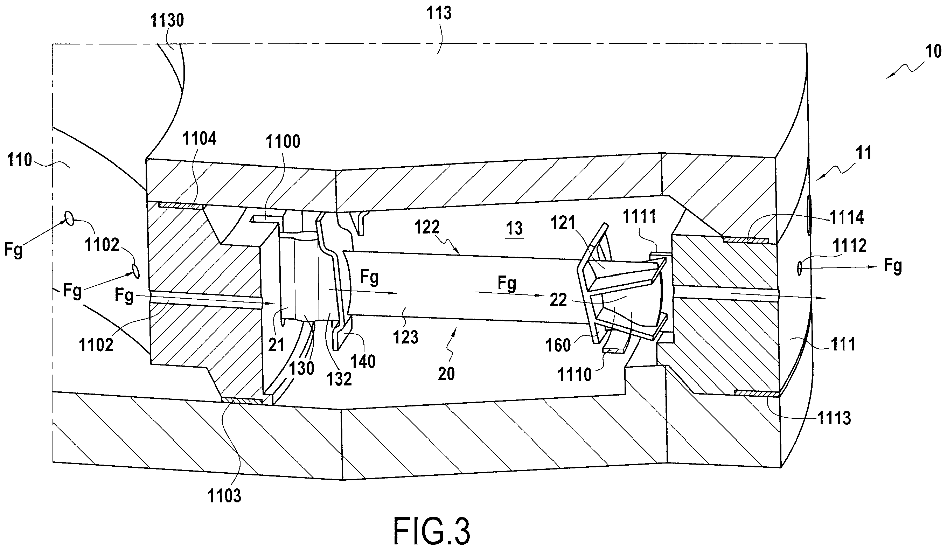

Chaque préforme 20 s'étend en direction longitudinale entre deux extrémités 21 et 22 et comprend une pale 120 et un pied 130 formé par une partie de plus forte épaisseur, par exemple à section en forme de bulbe, prolongé par une échasse 132 (figure 3). La pale 120 s'étend en direction longitudinale entre son pied 130 et son sommet 121 et présente en section transversale un profil incurvé d'épaisseur variable délimitant deux faces 122 et 123, correspondant respectivement à l'extrados et à l'intrados de la pale 120. Dans l'exemple décrit ici, la pale 120 comprend en outre une plateforme d'aube 140 et un talon d'aube 160.

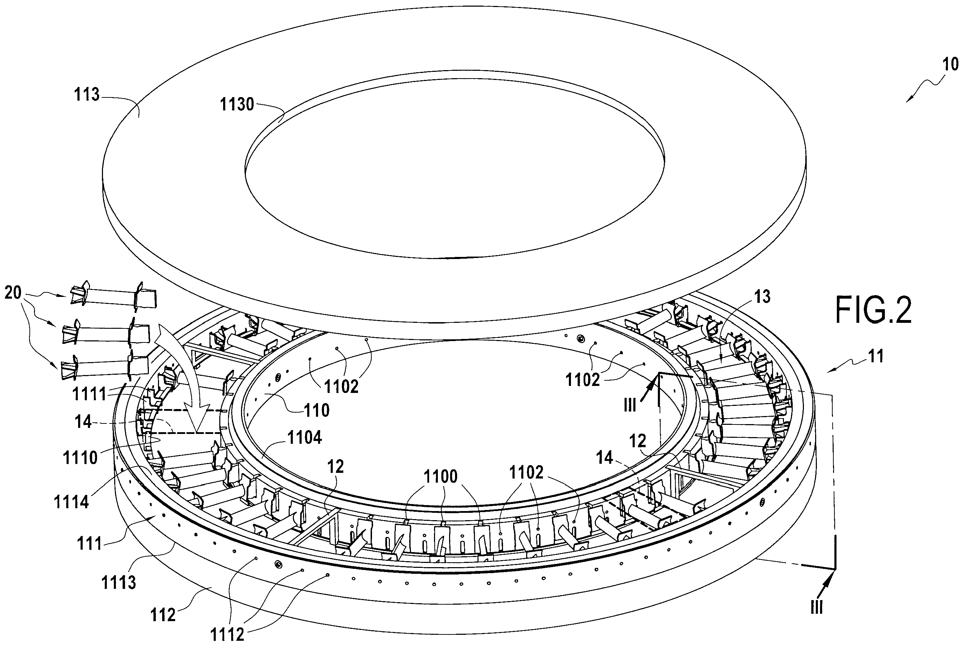

Le dispositif de chargement 10 décrit ici comprend un étage de chargement annulaire 11 (figure 2) formé par une première enceinte verticale annulaire interne 110 et une seconde enceinte verticale annulaire externe 111. Les enceintes 110 et 111 sont maintenues concentriquement l'une par rapport à l'autre par des entretoises 12 de manière à délimiter entre elles un espace de chargement annulaire 13 pour les préformes 20. Chaque enceinte verticale est munie d'éléments de support destinés à recevoir un des extrémités 21 et 22 des préformes d'aube 20. Plus précisément, l'enceinte verticale annulaire interne 110 comporte des encoches 1100 réparties uniformément sur la périphérie externe de l'enceinte 110. Les encoches 1100 sont destinées à recevoir les extrémités 21 des préformes 20. L'enceinte verticale annulaire externe 111 comporte un anneau 1110 fixé sur la partie inférieure des entretoises 12. L'anneau 1110 est destiné à supporter les extrémités 22 des préformes 20. Dans l'exemple décrit ici, l'anneau 1110 comprend en outre une pluralité de paires d'intercalaires 1111 permettant de séparer les extrémités 22 des aubes adjacentes. Chaque paire d'intercalaires 1111 est radialement alignée avec une encoche 1100 de manière à délimiter une cellule de chargement unitaire 14 (figure 2) destinée à recevoir une préforme 20. Une fois positionnées dans le dispositif de chargement 10, les préformes 20 s'étendent radialement entre les enceintes 110 et 111, ce qui permet d'optimiser la capacité de chargement de l'outillage. Par ailleurs, l'utilisation de moyens de support au niveau des enceintes verticales annulaires permet de minimiser la surface de contact entre les substrats à densifier et le dispositif de chargement, et d'offrir, en conséquence, une surface accessible optimale pour l'infiltration du gaz réactif.

Conformément à un premier mode de réalisation de l'invention, les enceintes 110 et 111 comportent chacune une pluralité d'orifice de passage de gaz. Plus précisément, l'enceinte verticale annulaire interne 110 comporte des orifices 1102 chacun disposés entre deux encoches adjacentes de manière à alimenter simultanément deux cellules de chargement unitaire 14 adjacentes. L'enceinte verticale annulaire externe 111 comporte des orifices 1112 chacun disposés au niveau d'une cellule de chargement unitaire.

L'espace de chargement annulaire 13 délimité entre les enceintes 110 et 111 est fermé dans sa partie inférieure par un premier plateau 112 et dans partie supérieure par un deuxième plateau 113. Le deuxième plateau 113 présente une ouverture centrale 1130 destinée à être reliée à une conduite d'alimentation en gaz réactif d'une chambre de réaction d'une installation ou four de densification de manière à alimenter les orifices 1102 en gaz réactif. Afin d'assurer une bonne étanchéité de l'espace de chargement annulaire 13, l'enceinte verticale annulaire interne 110 comprend deux joints annulaires 1103 et 1104 placés respectivement sur ses bords inférieur et supérieur tandis que l'enceinte verticale annulaire externe 111 comprend également deux joints annulaires 1113 et 1114 placés respectivement sur ses bords inférieur et supérieur.

La figure 3 illustre le dispositif de chargement 10 en configuration de densification, c'est-à-dire avec les préformes 20 chargées et les plateaux 112 et 113 montés respectivement sur les bords inférieur et supérieur des enceintes 110 et 111. Comme décrit plus loin en détail, le dispositif de chargement 10 est placé dans une chambre de réaction d'une installation ou four d'infiltration chimique en phase vapeur dans laquelle est admis un flux de gaz réactif Fg. Le flux de gaz réactif Fg est introduit dans l'espace de chargement annulaire 13 par les orifices 1102 de l'enceinte verticale annulaire interne 110. Le gaz résiduel est évacué par les orifices 1112 de l'enceinte verticale annulaire externe 111. Grâce à la disposition radiale des préformes 20 dans le dispositif de chargement 10 et à la présence des orifices de passages de gaz 1102 et 1112 au niveau de chaque cellule de chargement unitaire, il est possible de diriger le flux de gaz réactif sur toute la longueur et au plus près des préformes 20 à densifier et d'obtenir ainsi une densification homogène de ces dernières.

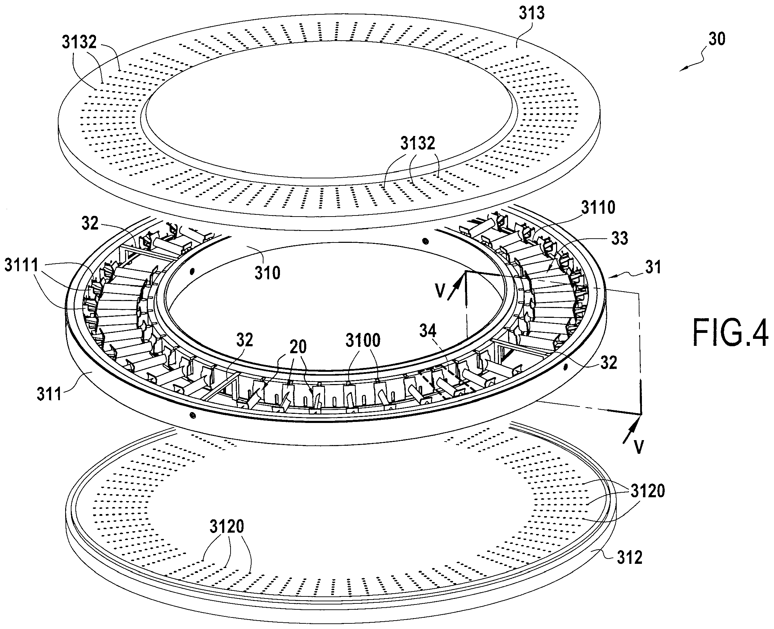

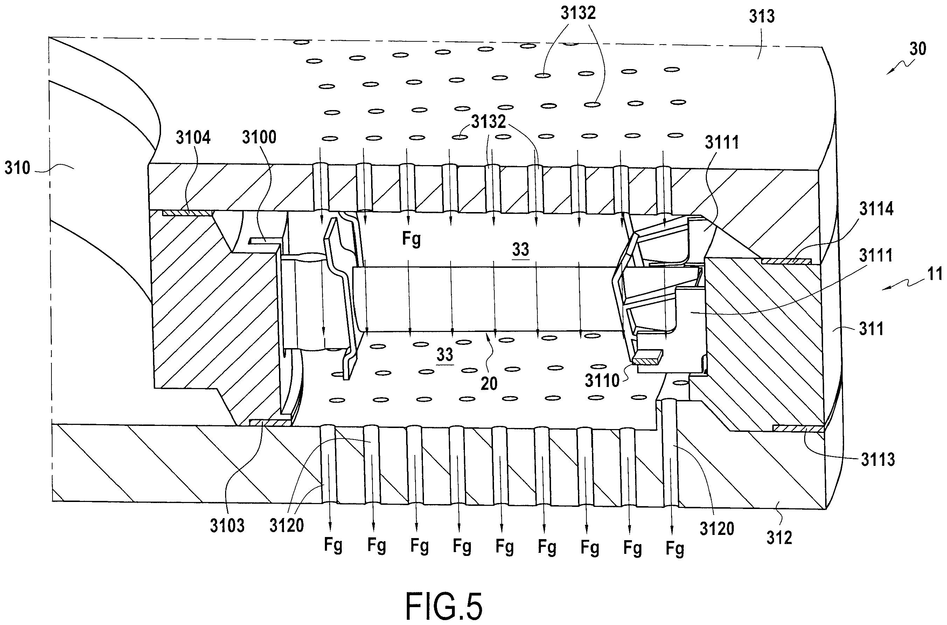

Les figures 4 et 5 montrent un dispositif de chargement 30 qui se distingue du dispositif 10 décrit ci-avant en ce que les orifices de circulation de gaz réactif dans l'espace annulaire de chargement sont ménagés au niveau des plateaux annulaires de fermeture de l'espace de chargement.

De même que pour le dispositif 10 illustré sur les figures 1 et 2, le dispositif de chargement 30 comprend un étage de chargement annulaire 31 formé par une première enceinte verticale annulaire interne 310 et une seconde enceinte verticale annulaire externe 311 maintenues concentriquement l'une par rapport à l'autre par des entretoises 32 de manière à délimiter entre elles un espace de chargement annulaire 33 pour les préformes 20. L'enceinte verticale annulaire interne 310 comporte des encoches 3100 tandis que l'enceinte verticale annulaire externe 311 comporte un anneau 3110 fixé sur la partie inférieure des entretoises 32 muni d'une pluralité de paires d'intercalaires 3111. L'espace présent entre chaque paire d'intercalaires 3111 et l'encoche 3100 en regard forme une cellule de chargement unitaire 34 pour une préforme 20. Les préformes 20 sont disposées dans les cellules de chargements unitaire 34 et s'étendent radialement entre les enceintes 310 et 311.

L'espace de chargement annulaire 33 délimité entre les enceintes 310 et 311 est fermé dans sa partie inférieure par un premier plateau annulaire 312 et dans partie supérieure par un deuxième plateau annulaire 313, des joints annulaires 3103, 3104, 3113 et 3114 assurant une bonne étanchéité entre les plateaux 312 et 313 et les enceintes 310 et 311.

Dans le mode de réalisation décrit ici, les plateaux 312 et 313 comportent chacun des orifices pour permettre le passage d'un gaz réactif dans l'espace de chargement annulaire 33. Plus précisément, les plateaux annulaires 312 et 313 comportent chacun respectivement une pluralité de séries d'orifices 3120 et 3132 qui s'étendent radialement au-dessous ou au-dessus de chaque cellule de chargement unitaire 34. Dans l'exemple décrit ici, le plateau annulaire inférieur 312 comporte une série de neuf orifices au-dessous de chaque cellule de chargement unitaire 34. De même, le plateau annulaire supérieur 313 comporte une série de neuf orifices au-dessus de chaque cellule de chargement unitaire 34.

Dans le cas du dispositif de chargement 30, le flux de gaz réactif Fg est introduit dans l'espace annulaire de chargement à partir des orifices 3120 ou 3132 et ses résidus sont évacués par les orifices 3132 ou 3120 (figure 5). On crée ainsi, au niveau de chaque cellule de chargement unitaire 34, une pluralité de chemins de circulation pour le gaz réactif répartis uniformément le long de la cellule de chargement, ce qui permet de couvrir l'ensemble de la préforme et d'obtenir une densification uniforme de cette dernière.

Les dispositifs de chargement décrits ci-avant comprennent un seul étage de chargement, c'est-à-dire un seul espace annulaire de chargement. Toutefois, le dispositif de chargement selon l'invention peut comprendre plusieurs étages de chargement disposés les uns par rapport aux autres de manière optimisée en ce qui concerne le taux d'occupation dans l'installation d'infiltration.

Selon un premier aspect de l'invention, le dispositif de chargement comprend plusieurs étages de chargement annulaires empilés les uns sur les autres.

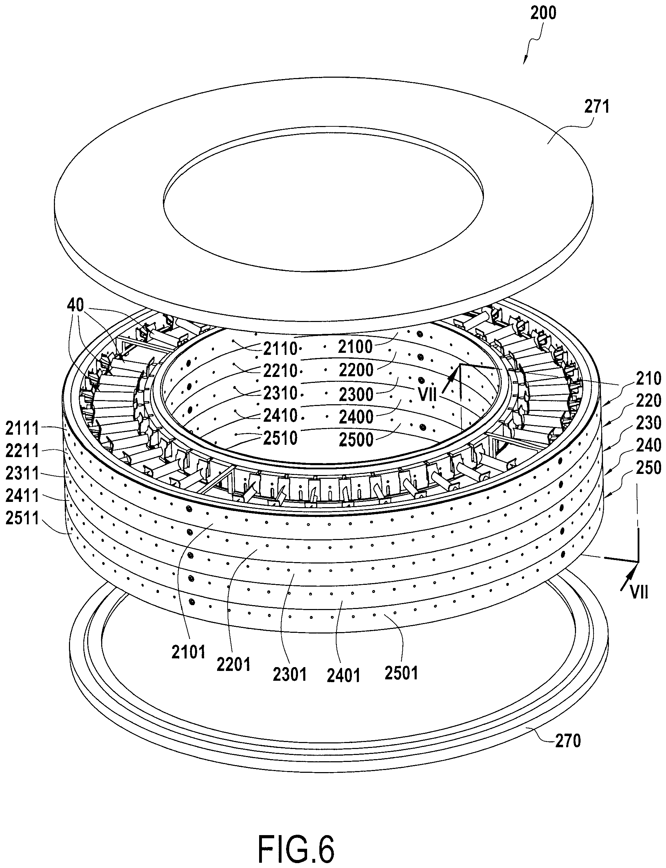

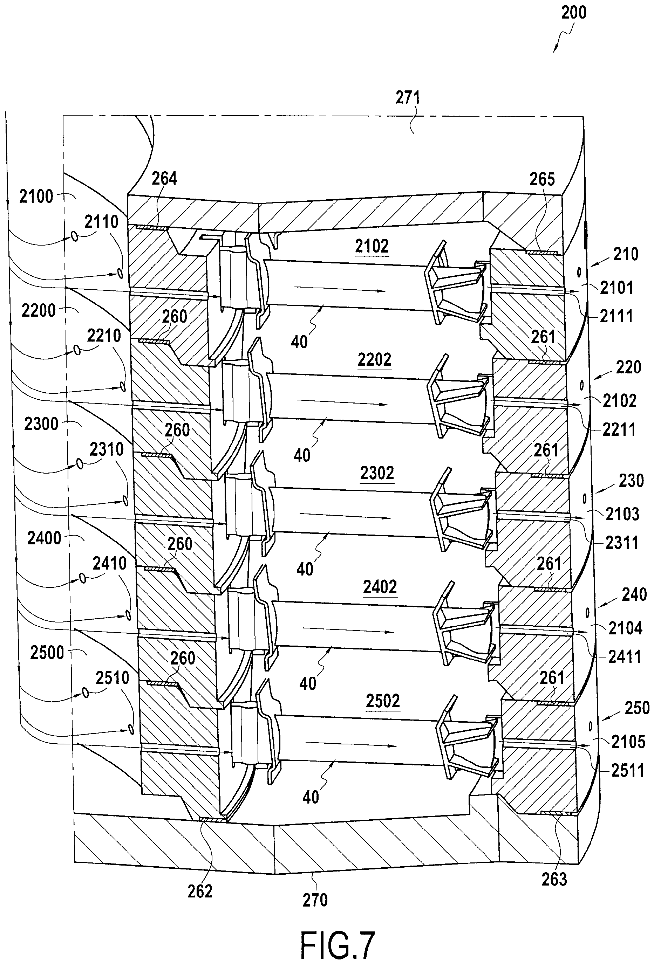

Les figures 6 et 7 illustrent un dispositif de chargement 200 comprenant plusieurs étages de chargement annulaires 210, 220, 230, 240, 250 empilés les uns sur les autres et formés respectivement par des enceintes verticales annulaires internes 2100, 2200, 2300, 2400, 2500 et des enceintes verticales annulaires externes 2101, 2201, 2301, 2401, 2501 et définissant entre elles un espace de chargement annulaire respectivement 2102, 2202, 2302, 2402, 2502. Chacun des étages 210, 220, 230, 240, 250 présente une structure similaire à celle de l'étage 11 décrit ci-avant en relation avec les figures 1 et 2 qui ne sera pas décrite de nouveau en détail par souci de simplification.

Des joints annulaires 260 et 261 sont disposés sur le bord supérieur des enceintes verticales annulaires respectivement internes 2200, 2300, 2400, 2500 et externes 2201, 2301, 2401, 2501 afin d'assurer une étanchéité entre les étages de chargement annulaires 210, 220, 230, 240, 250.

La partie inférieure du dispositif de chargement 200 constituée par l'étage de chargement annulaire 250 est fermée par un premier plateau annulaire 270 avec interposition de deux joints annulaires 262 et 263 entre le bord inférieur des enceintes verticales annulaires interne 2500 et externe 2501 de l'étage 250 tandis que la partie supérieure du dispositif de chargement 200 constituée par l'étage de chargement annulaire 210 est fermée par un deuxième plateau annulaire 271 avec interposition de deux joints annulaires 264 et 265 entre le bord supérieur des enceintes verticales annulaires interne 2100 et externe 2101 de l'étage 210.

Une fois les étages 210, 220, 230, 240, 250 chargés avec des préformes fibreuses d'aube 40, la pile constituée par le dispositif de chargement 200 est alimentée en son centre avec un gaz réactif dont le flux Fg pénètre dans les espaces de chargement annulaire 2102, 2202, 2302, 2402, 2502 des étages 210, 220, 230, 240, 250 respectivement par les orifices 2110, 2210, 2310, 2410, 2510 des enceintes verticales annulaires internes 2100, 2200, 2300, 2400. Après avoir traversé les espaces de chargement annulaire 2102, 2202, 2302, 2402, 2502, les résidus de gaz réactifs sont extraits par les orifices 2111, 2211, 2311, 2411, 2511 des enceintes verticales annulaires internes 2101, 2201, 2301, 2401.

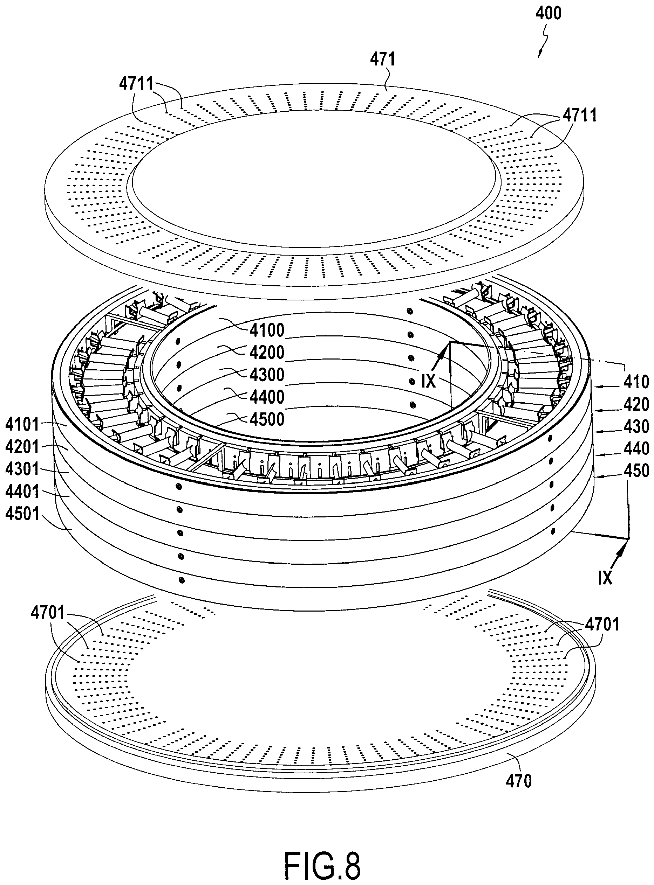

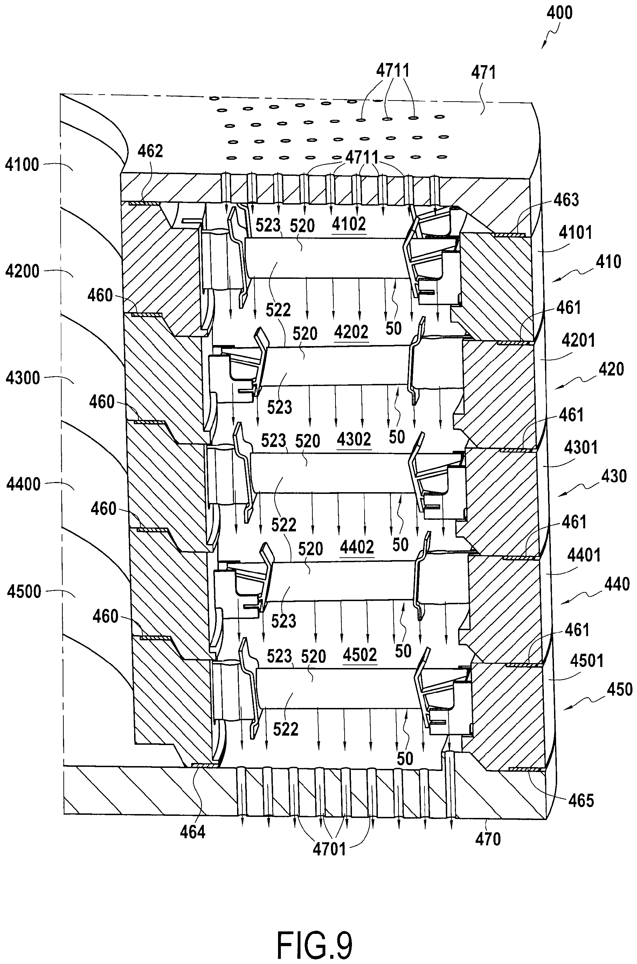

Les figures 8 et 9 illustrent un dispositif de chargement 400 comprenant plusieurs étages de chargement annulaires 410, 420, 430, 440, 450 empilés les uns sur les autres chacun définissant un espace de chargement annulaire respectivement 4102, 4202, 4302, 4402, 4502. Des préformes fibreuses d'aube 50 sont disposées dans chacun de ces espaces de chargement annulaires comme décrit précédemment. Chacun des étages 410, 420, 430, 440, 450 présente une structure similaire à celle de l'étage 31 décrit ci-avant en relation avec la figure 4 qui ne sera pas décrite de nouveau en détail par souci de simplification.

Des joints annulaires 460 et 461 sont disposés sur le bord supérieur des enceintes verticales annulaires respectivement internes 4200, 4300, 4400, 4500 et externes 4201, 4301, 4401, 4501 afin d'assurer une étanchéité entre les étages de chargement annulaires 410, 420, 430, 440, 450.

La partie inférieure du dispositif de chargement 400 constituée par l'étage de chargement annulaire 450 est fermée par un premier plateau annulaire 470 avec interposition de deux joints annulaires 462 et 463 entre le bord inférieur des enceintes verticales annulaires interne 4500 et externe 4501 de l'étage 410 tandis que la partie supérieure du dispositif de chargement 400 constituée par l'étage de chargement annulaire 410 est fermée par un deuxième plateau annulaire 471 avec interposition de deux joints annulaires 464 et 465 entre le bord supérieur des enceintes verticales annulaires interne 4100 et externe 4101 de l'étage 410.

Les plateaux 470 et 471 comportent chacun respectivement une pluralité de séries d'orifices 4701 et 4711 qui s'étendent radialement sur les plateaux. Lors de la densification des préformes fibreuses 50 dans le dispositif de chargement 50, un flux Fg gaz réactif est introduit par exemple à partir des orifices 4711 et parcours successivement les espaces de chargement annulaire 4102, 4202, 4302, 4402, 4502. Dans ce cas les résidus de gaz réactif sont évacués du dispositif de chargement 400 par les orifices 4701. Bien entendu, la circulation du gaz réactif dans le dispositif peut se faire dans le sens inverse, c'est-à-dire être introduit dans celui-ci par les orifices 4701 et être évacué par les orifices 4711.

Dans le cas d'une densification de préformes fibreuses d'aube avec un dispositif de chargement comprenant plusieurs étages annulaires de chargement alimentés en gaz réactif par les orifices des plateaux de fermeture comme pour le dispositif de chargement 400, la Déposante a constaté qu'un meilleur écoulement du flux de gaz réactif était obtenu lorsque les pales de préformes d'aubes sont orientées différemment entre deux étages de chargement adjacents. Plus précisément, comme illustrées sur la figure 9, les préformes d'aubes 50 présentes dans les étages de chargement annulaire 410, 430 et 450 sont disposées dans ceux-ci avec la face extrados 522 de leur pale 520 orientée dans le sens horaire de l'espace de chargement annulaire correspondant tandis que les préformes d'aube 50 présentes dans les étages 420 et 440 sont disposées dans ceux-ci avec la face extrados 522 de leur pale 520 orientée dans le sens antihoraire de l'espace de chargement annulaire correspondant. En orientant les faces intrados (ou extrados) des préformes d'aubes alternativement dans un sens horaire et un sens antihoraire d'un étage de chargement à l'autre dans la pile, on réalise une meilleure répartition de la phase gazeuse entre les préformes situées au plus près de l'entrée du gaz réactif dans le dispositif de chargement et celles les plus éloignées de cette entrée, ce qui permet d'obtenir, par conséquent, une densification plus homogène des préformes dans le dispositif de chargement.

Selon un deuxième aspect de l'invention, le dispositif de chargement comprend plusieurs étages de chargement annulaires disposés concentriquement les uns par rapport aux autres.

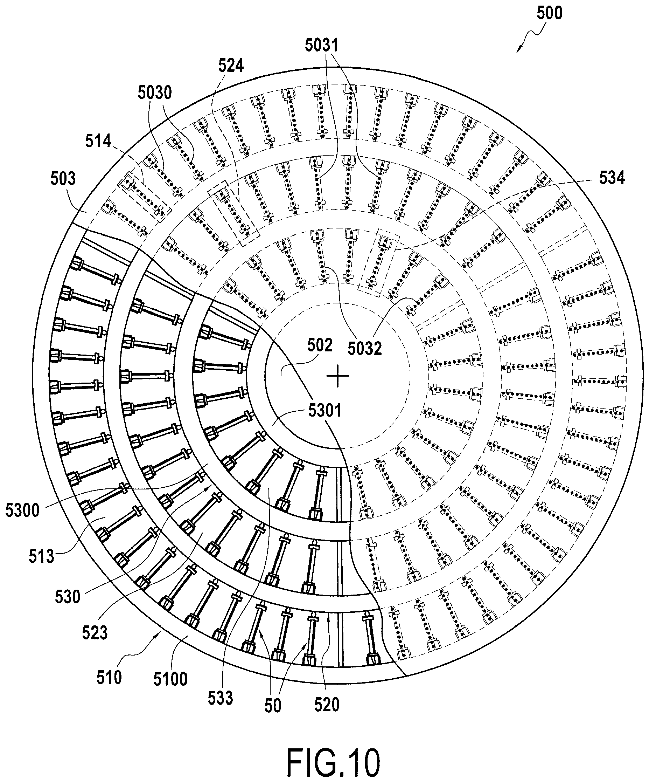

La figure 10 illustre un dispositif de chargement 500 comprenant plusieurs étages de chargement annulaires 510, 520, 530 présentant des diamètres différents et disposés concentriquement les uns par rapport aux autres. Chacun des étages 510, 520, 530 présente une structure similaire à celle de l'étage 31 décrit ci-avant en relation avec la figure 4 qui ne sera pas décrite de nouveau en détail par souci de simplification. Dans l'exemple décrit ici, le dispositif de chargement comprend quatre enceintes verticales annulaires 5100, 5200, 5300 et 5301 présentant respectivement des diamètres décroissants. L'étage 510 comprend un espace de chargement annulaire 513 délimité par les enceintes verticales annulaires 5100 et 5200. L'étage 520 comprend un espace de chargement annulaire 523 délimité par les enceintes verticales annulaires 5200 et 5300. Enfin, l'étage 530 comprend un espace de chargement annulaire 533 délimité par les enceintes verticales annulaires 5300 et 5301. Des préformes fibreuses d'aube 60 sont chargées dans chacun des espaces annulaires de chargement 513, 523, 533 respectivement des étages 510, 520 et 530.

La partie inférieure du dispositif de chargement 500 est fermée par un premier plateau 502 tandis que la partie supérieure du dispositif de chargement 500 est fermée par un deuxième plateau annulaire 503. Comme décrit précédemment pour le dispositif de chargement 30 de la figure 4, les plateaux 502 et 503 comportent chacun des orifices pour permettre le passage d'un gaz réactif dans l'espace de chargement annulaire.

Plus précisément, comme représenté sur la figure 10, le plateau 503 comporte une première pluralité de séries d'orifices 5030 qui sont répartis autour de l'espace de chargement annulaire 513 de l'étage 510, chaque série s'étendant radialement au-dessus de chaque cellule de chargement unitaire 514. De même, le plateau 503 comporte une deuxième pluralité de séries d'orifices 5031 qui sont répartis autour de l'espace de chargement annulaire 523 de l'étage 520, chaque série s'étendant radialement au-dessus de chaque cellule de chargement unitaire 524. Enfin, le plateau 503 comporte une troisième pluralité de séries d'orifices 5032 qui sont répartis autour de l'espace de chargement annulaire 523 de l'étage 520, chaque série s'étendant radialement au-dessus de chaque cellule de chargement unitaire 534. Des première, deuxième et troisième séries d'orifices de circulation de gaz sont réalisées de façon similaire dans le plateau 502 (non représenté sur la figure 10).

Dans le cas du dispositif de chargement 500, le flux de gaz réactif est introduit dans les espaces annulaires de chargement 513, 523 et 533 à partir des orifices de circulation de gaz ménagés dans le plateau 502 ou le plateau 503 et ses résidus sont évacués par les orifices de circulation de gaz ménagés dans le plateau 503 ou le plateau 502.

Selon une variante de réalisation, le dispositif de chargement comprenant plusieurs étages de chargement annulaires présentant des diamètres différents et disposés concentriquement les uns par rapport aux autres comme illustré dans la figure 10 mais avec chacun des étages concentriques présentant une structure similaire à celle de l'étage 11 décrit ci-avant en relation avec la figure 2. Dans ce cas, les orifices de passage de gaz des enceintes verticales annulaires communes à deux étages de chargement adjacent sont placés de manière à déboucher au niveau des cellules de chargement unitaire des deux étages adjacents. Dans ce cas on augmente la quantité de gaz réactif introduit dans le premier étage de chargement afin que celui-ci reste en quantité suffisante dans tous les autres étages concentriques dans lesquels il doit circuler.

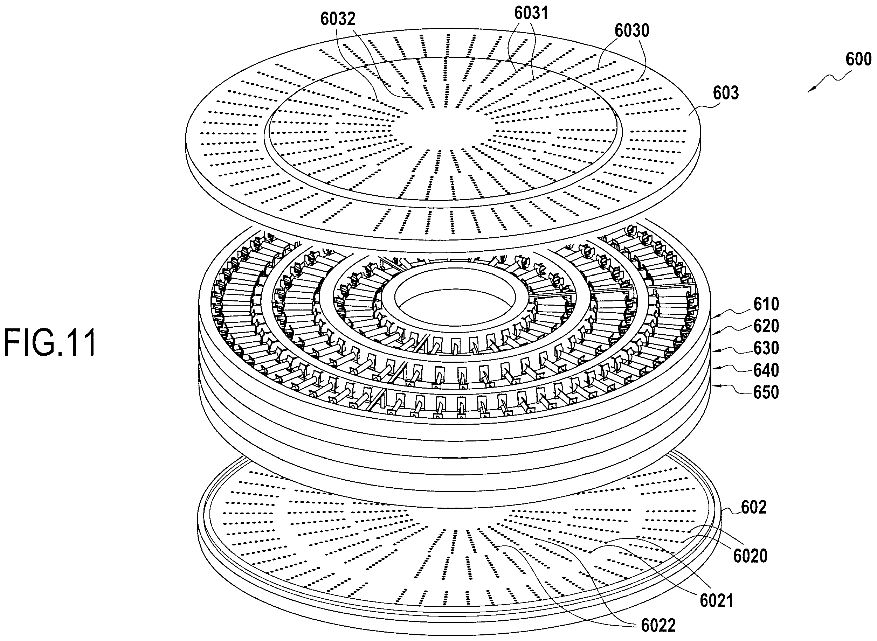

Le dispositif de chargement selon l'invention peut également comprendre un pluralité d'étages de chargement annulaires qui sont disposés pour une partie d'entre eux concentriquement les uns par rapport aux autres et empilés les uns sur les autres pour l'autre partie d'entre eux comme représenté sur la figure 11 qui montre un dispositif de chargement 600 comprenant cinq sous-dispositifs de chargement 610, 620, 630, 640 et 650 similaires au dispositif de chargement 500 de la figure 10, c'est-à-dire constitués chacun de trois étages de chargement disposés concentriquement les uns par rapport aux autres. Les cinq sous-dispositifs de chargement 610, 620, 630, 640 et 650 sont en outre empilés les uns sur les autres, la partie inférieure de l'empilement constituée par l'étage 650 étant fermée par un plateau 602 comportant trois séries d'orifices de circulation de gaz 6020, 6021 et 6022 répartis autour de l'espace de chargement annulaire de l'étage 650, chaque série s'étendant radialement au-dessus de chaque cellule de chargement unitaire. De même, la partie supérieure de l'empilement constituée par l'étage 610 est fermée par un plateau 603 comportant trois séries d'orifices de circulation de gaz 6030, 6031 et 6032 répartis autour de l'espace de chargement annulaire de l'étage 610, chaque série s'étendant radialement au-dessus de chaque cellule de chargement unitaire.

Le dispositif de chargement de l'invention, qu'il comprenne un ou plusieurs étages de chargement annulaires empilés et/ou disposés concentriquement, se comporte comme un mini-réacteur permettant la densification des substrats qu'il contient de façon indépendante. Par conséquent, lorsque la capacité de la chambre de réaction du four ou de l'installation de densification le permet, plusieurs dispositifs peuvent être disposés dans une même chambre. De nombreuses configurations de chargement peuvent être ainsi envisagées.

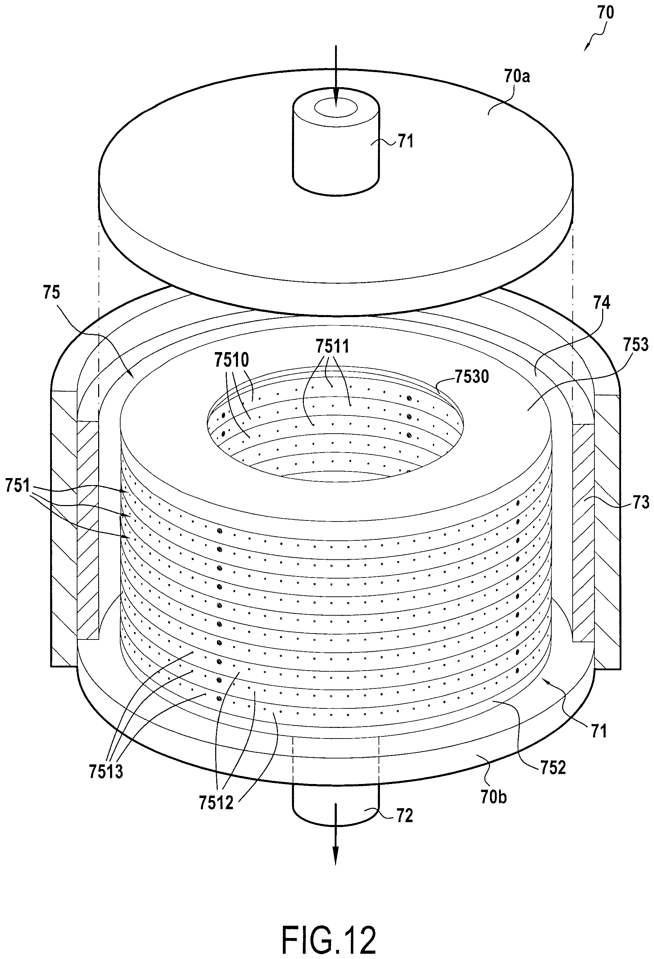

La figure 12 représente schématiquement une chambre de réaction 70 d'une installation ou four d'infiltration chimique en phase vapeur dans laquelle sont chargés des substrats à densifier. La chambre 70 a une forme généralement cylindrique.

Afin d'assurer la densification des substrats, un gaz réactif contenant un ou plusieurs précurseurs du matériau de la matrice à déposer est introduit dans la chambre 70. Dans le cas du carbone par exemple, on utilise des composés gazeux hydrocarbonés, typiquement du propane, du méthane ou un mélange des deux. Dans le cas d'un matériau céramique, comme du carbure de silicium (SiC) par exemple, on peut utiliser, comme bien connu en soi, du méthyltrichlorosilane (MTS) en tant que précurseur de SiC.

La densification des substrats poreux est assurée, de façon bien connue en soi, par dépôt au sein de ceux-ci du matériau de la matrice produit par décomposition du précurseur contenu dans le gaz réactif diffusant à l'intérieur de la porosité interne accessible des substrats. Les conditions de pression et de température nécessaires pour obtenir des dépôts de matrices diverses par infiltration chimique en phase vapeur sont bien connues en elles-mêmes.

Dans l'exemple illustré, le gaz réactif est amené par une conduite d'admission 71 qui débouche dans la partie supérieure de la chambre. Le gaz résiduel est extrait à la partie inférieure de la chambre par une conduite d'évacuation 72 qui est reliée à des moyens d'aspiration (non représentés).

Le chauffage à l'intérieur de la chambre est produit par un suscepteur en graphite 73 formant un induit couplé électromagnétiquement avec un inducteur (non représenté). Le suscepteur 73 délimite le volume interne 74 de la chambre avec le couvercle 70a traversé par la conduite 71 et le fond 70b traversé par la conduite 72. Le fond et le couvercle sont également en graphite.

Afin de réaliser la densification de substrats poreux, comme par exemple des préformes fibreuses d'aube, ces derniers sont chargés dans le volume interne 74 de la chambre 70 au moyen d'un dispositif de chargement 75 formé d'une pluralité d'étages de chargement 751 disposés entre un plateau inférieur 752 et un plateau supérieur 753. La structure et le fonctionnement du dispositif de chargement 75 sont similaires à ceux du dispositif 200 décrit en relation avec les figures 6 et 7. L'ouverture centrale 7530 du plateau supérieur 753 est reliée à la conduite d'admission en gaz réactif 71 afin d'alimenter les étages de chargement 751 du dispositif 75 via les orifices d'alimentation en gaz 7511 présents sur les enceintes internes 7510 desdits étages. Le gaz résiduel évacué par les orifices d'évacuation 7513 présents sur les enceintes externes 7512 des étages de chargement 751 du dispositif 75 est extrait de la chambre par la conduite d'évacuation 72. La circulation du flux de gaz réactif dans le dispositif de chargement 75 se fait comme illustré dans la figure 7.

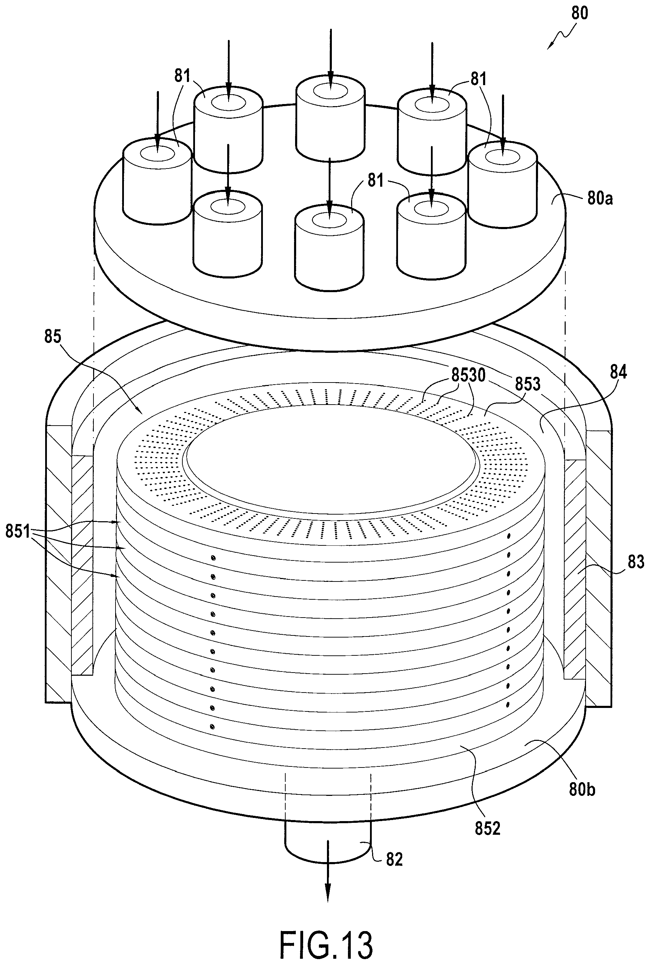

La figure 13 représente schématiquement une chambre de réaction 80 d'une installation ou four d'infiltration chimique en phase vapeur dont le volume interne 84 est délimité par un suscepteur 83, un couvercle 80a traversé par une pluralité de conduites d'alimentation en gaz réactif 81 et un fond 80b traversé par une conduite d'évacuation 82. Des substrats poreux, comme par exemple des préformes fibreuses d'aube, sont chargés à l'intérieur de la chambre 80 au moyen d'un dispositif de chargement 85 formé d'une pluralité d'étages de chargement 851 disposés entre un plateau inférieur 852 et un plateau supérieur 853. La structure et le fonctionnement du dispositif de chargement 85 sont similaires à ceux du dispositif 200 décrit en relation avec les figures 8 et 9. Les orifices d'alimentation du plateau supérieur 853 sont reliés aux conduites d'admission en gaz réactif 81 afin d'alimenter les étages de chargement 851 du dispositif 85. Le gaz résiduel évacué par les orifices d'évacuation (non représentés sur la figure 13) présents sur le plateau inférieur 852 est extrait de la chambre par la conduite d'évacuation 82. La circulation du flux de gaz réactif dans le dispositif de chargement 85 se fait comme illustré dans la figure 9.

La chambre de réaction 80 peut être également chargée de substrats poreux, comme par exemple des préformes fibreuses d'aube, au moyen d'un dispositif de chargement similaire à celui de la figure 11.

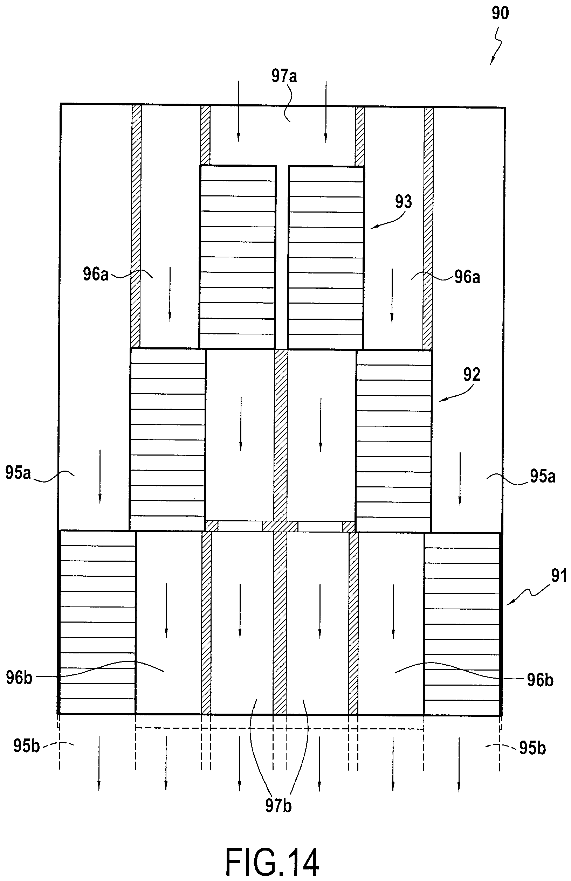

La figure 14 montre une autre configuration possible de chargement suivant une structure pyramidale. Cette configuration consiste à empiler dans une chambre de réaction 90 d'une installation ou four d'infiltration chimique en phase vapeur plusieurs dispositifs de chargement, ici trois dispositifs de chargement 91, 92 et 93, ayant des diamètres décroissants. La structure et le fonctionnement des dispositifs de chargement 91, 92 et 93 sont similaires à ceux du dispositif 400 décrit en relation avec les figures 8 et 9. Le gaz réactif est introduit dans les dispositifs de chargement 91, 92 et 93 respectivement par des conduites d'admission 95a, 96a et 97a. Le gaz résiduel provenant des dispositifs de chargement 91, 92 et 93 est évacué respectivement par des conduites d'évacuation 95b, 96b et 97b.

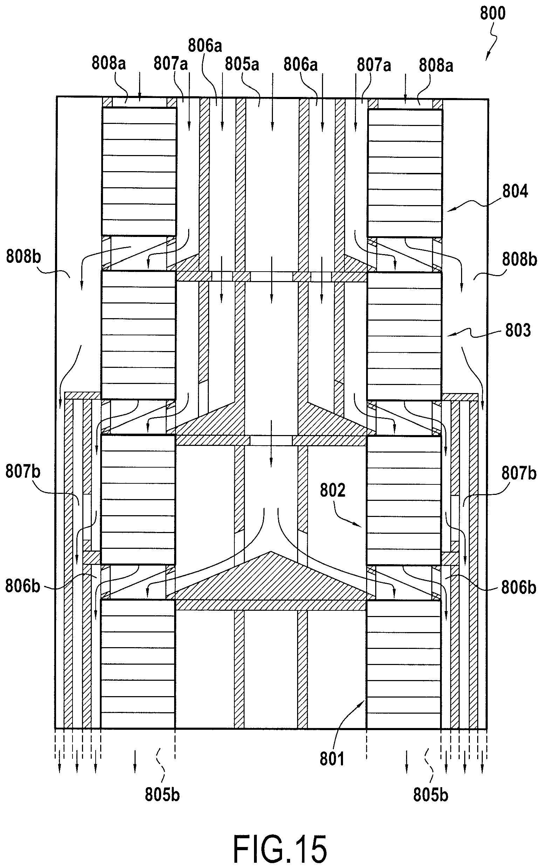

Selon encore une autre configuration de chargement possible illustrée en figure 15, on empile dans une chambre de réaction 800 d'une installation ou four d'infiltration chimique en phase vapeur plusieurs dispositifs de chargement, ici quatre dispositifs de chargement 801 à 804 de même diamètre. La structure et le fonctionnement des dispositifs de chargement 801 à 804 sont similaires à ceux du dispositif 400 décrit en relation avec les figures 8 et 9. Le gaz réactif est introduit dans les dispositifs de chargement 801 à 804 respectivement par des conduites d'admission 805a, 806a, 807a et 808a. Le gaz résiduel provenant des dispositifs de chargement 801 à 804 est évacué respectivement par des conduites d'évacuation 805b, 806b, 807b et 808b.

Tous les éléments du dispositif de chargement de l'invention (enceintes, plateaux, éléments de support des substrats, ...) sont par exemple en graphite, en graphite expansé ou en un matériau composite C/C.

Dans le cas d'un chargement multiple constitué de plusieurs dispositifs de chargement, eux-mêmes pouvant comprendre plusieurs étages de chargement, l'adaptation de l'installation de densification consiste seulement à alimenter en gaz réactif chaque miniréacteur constitué par un dispositif. Les débits de gaz réactif sont simplement multipliés par le nombre de dispositifs à alimenter et le nombre d'étages de chargement par dispositif. Par ailleurs, les problèmes d'écoulement en zone morte rencontrés avec les procédés à flux libre dans les chambres de réaction de grandes tailles sont éliminés par l'utilisation des dispositifs de chargement de l'invention.

Le dispositif de chargement de l'invention présente en outre l'intérêt de permettre la préparation du chargement à l'avance, c'est-à-dire en dehors du local technique du four d'infiltration et de transporter les substrats à densifier avec un moindre risque jusque dans la chambre de réaction, contrairement aux outillages standards habituellement utilisés en flux libre. Le temps de chargement/déchargement des fours d'infiltration chimique en phase gazeuse est ainsi réduit et les manipulations facilitées.

## Revendications

1. Dispositif de chargement (10) pour la densification, par infiltration chimique en phase vapeur en flux dirigé, dans une chambre de réaction d'un four d'infiltration, de substrats poreux (20) de forme tridimensionnelle s'étendant principalement dans une direction longitudinale, **caractérisé en ce qu'**il comprend :
au moins un étage de chargement annulaire (11) formé par des première et deuxième enceintes verticales annulaires (110, 111) disposées concentriquement l'une par rapport à l'autre et délimitant entre elles un espace de chargement annulaire (13) pour les substrats poreux à densifier,
des premier et deuxième plateaux (112, 113) couvrant respectivement la partie inférieure et la partie supérieure de l'espace de chargement annulaire (13),
les première et deuxième enceintes verticales annulaires (110, 111) comprenant chacune des éléments de support (1100, 1110) répartis dans l'espace de chargement annulaire (13), les éléments de support des première et deuxième enceintes verticales annulaires étant radialement alignés de manière à définir entre eux des cellules de chargement unitaire (14) destinées à recevoir chacune un substrat à densifier,
le dispositif comprenant en outre au moins un orifice d'alimentation en gaz (1102) et un orifice d'évacuation de gaz (1112) au voisinage de chaque cellule de chargement unitaire.

2. Dispositif selon la revendication 1, **caractérisé en ce que** la première enceinte verticale annulaire (110) de chaque étage de chargement (11) comporte au moins un orifice d'alimentation en gaz (1102) au voisinage de chaque cellule de chargement unitaire (14) et **en ce que** la deuxième enceinte verticale annulaire (111) de chaque étage de chargement comporte au moins un orifice d'évacuation de gaz (1112) au voisinage de chaque cellule de chargement unitaire (14).

3. Dispositif selon la revendication 2, **caractérisé en ce qu'**il comprend plusieurs étages de chargement annulaires (210, 220, 230, 240, 250) empilés les uns sur les autres et disposés entre les premier et deuxième plateaux (270, 271).

4. Dispositif selon la revendication 1, **caractérisé en ce que** le premier plateau (313) comporte des orifices d'alimentation en gaz (3132) au niveau de chaque cellule de chargement unitaire (34) et **en ce que** le deuxième plateau (312) comporte des orifices d'évacuation de gaz (3120) au niveau de chaque cellule de chargement unitaire (34).

5. Dispositif selon la revendication 4, **caractérisé en ce qu'**il comprend plusieurs étages de chargement annulaires (410, 420, 430, 440, 450) empilés les uns sur les autres et disposés entre les premier et deuxième plateaux (470, 472).

6. Dispositif selon la revendication 4 ou 5, **caractérisé en ce qu'**il comprend en outre plusieurs étages de chargement annulaires (510, 520, 530) ayant des dimensions radiales différentes, lesdits étages étant disposés concentriquement les uns par rapport aux autres.

7. Installation de densification par infiltration chimique en phase vapeur de substrats poreux de forme tridimensionnelle s'étendant principalement dans une direction longitudinale, comportant une chambre de réaction (70), une conduite d'admission de gaz réactif (71) située à une première extrémité de la chambre, et une conduite d'évacuation (72) située au voisinage d'une seconde extrémité de la chambre opposée à la première,
**caractérisée en ce que** la chambre comprend une pluralité de substrats poreux de forme tridimensionnelle s'étendant principalement dans une direction longitudinale, lesdits substrats étant disposés dans un dispositif de chargement (75) selon l'une quelconque des revendications 3, 5 et 6, le ou les orifices d'alimentation en gaz dudit dispositif étant alimentés en gaz réactif par la conduite d'admission de gaz réactif de la chambre.

8. Installation de densification par infiltration chimique en phase vapeur de substrats poreux de forme tridimensionnelle s'étendant principalement dans une direction longitudinale, comportant une chambre de réaction (80), une pluralité de conduites d'admission de gaz réactif (81) situées à une première extrémité de la chambre, et au moins une conduite d'évacuation (82) située au voisinage d'une seconde extrémité de la chambre opposée à la première,
**caractérisée en ce que** la chambre comprend une pluralité de substrats poreux de forme tridimensionnelle s'étendant principalement dans une direction longitudinale, lesdits substrats étant disposés dans au moins un dispositif de chargement (85) selon la revendication 5 ou 6, le ou les orifices d'alimentation en gaz de chaque dispositif étant alimentés en gaz réactif par les conduites d'admission de gaz réactif (81) de la chambre.

9. Installation selon la revendication 8, **caractérisée en ce que** la chambre comprend une pluralité de dispositifs de chargement (91, 92, 93) de diamètre décroissant empilés les uns sur les autres.

10. Installation selon la revendication 8 ou 9, **caractérisée en ce que** la chambre comprend une pluralité de dispositifs de chargement (801, 802, 803, 804) de même diamètre empilés les uns sur les autres.

## Patentansprüche

1. Ladevorrichtung (10) zur Verdichtung dreidimensionaler poröser Substrate (20), die sich hauptsächlich in Längsrichtung erstrecken, mittels chemischer Infiltration in der Dampfphase in gerichteter Strömung in einer Reaktionskammer eines Infiltrationsofens, **dadurch gekennzeichnet, dass** sie umfasst:
mindestens eine ringförmige Ladestufe (11), die durch erste und zweite ringförmige vertikale Einhausungen (110, 111) gebildet ist, die konzentrisch zueinander angeordnet sind und zwischen sich einen ringförmigen Laderaum (13) für die zu verdichtenden porösen Substrate abgrenzen,
erste und zweite Platten (112, 113) die jeweils den unteren und oberen Teil des ringförmigen Laderaums (13) abdecken,
wobei die erste und die zweite ringförmige vertikale Einhausung (110, 111) jeweils Stützelemente (1100, 1110) umfassen, die in dem ringförmigen Laderaum (13) verteilt sind, wobei die Stützelemente der ersten und zweiten ringförmigen vertikalen Einhausung radial so ausgerichtet sind, dass zwischen ihnen Einheitsladezellen (14) definiert werden, die jeweils dazu bestimmt sind, ein zu verdichtendes Substrat aufzunehmen,
wobei die Vorrichtung ferner mindestens eine Gasversorgungsöffnung (1102) und eine Gasaustrittsöffnung (1112) in der Nähe jeder Einheitsladezelle aufweist.

2. Vorrichtung gemäß Anspruch 1, **dadurch gekennzeichnet, dass** die erste ringförmige vertikale Einhausung (110) jeder Ladestufe (11) mindestens eine Gasversorgungsöffnung (1102) in der Nähe jeder Einheitsladezelle (14) aufweist und dass die zweite ringförmige vertikale Einhausung (111) jeder Ladestufe mindestens eine Gasaustrittsöffnung (1112) in der Nähe jeder Einheitsladezelle (14) aufweist.

3. Vorrichtung gemäß Anspruch 2, **dadurch gekennzeichnet, dass** sie mehrere ringförmige Ladestufen (210, 220, 230, 230, 240, 250) umfasst, die übereinander gestapelt und zwischen den ersten und zweiten Platten (270, 271) angeordnet sind.

4. Vorrichtung gemäß Anspruch 1, **dadurch gekennzeichnet, dass** die erste Platte (313) Gasversorgungsöffnungen (3132) bei jeder Einheitsladezelle (34) aufweist und dass die zweite Platte (312) Gasaustrittsöffnungen (3120) bei jeder Einheitsladezelle (34) aufweist.

5. Vorrichtung gemäß Anspruch 4, **dadurch gekennzeichnet, dass** sie mehrere ringförmige Ladestufen (410, 420, 430, 440, 450) umfasst, die übereinander gestapelt und zwischen den ersten und zweiten Platten (470, 472) angeordnet sind.

6. Vorrichtung gemäß Anspruch 4 oder 5, **dadurch gekennzeichnet, dass** sie ferner mehrere ringförmige Ladestufen (510, 520, 530) mit unterschiedlichen radialen Abmessungen umfasst, wobei die Stufen konzentrisch zueinander angeordnet sind.

7. Anlage zur Verdichtung dreidimensionaler poröser Substrate, die sich hauptsächlich in Längsrichtung erstrecken, mittels chemischer Infiltration in der Dampfphase, umfassend eine Reaktionskammer (70), ein Reaktivgaseintrittsrohr (71), das an einem ersten Ende der Kammer angeordnet ist, und ein Auslassrohr (72), das sich in der Nähe eines zweiten Endes der Kammer gegenüber dem ersten befindet,
**dadurch gekennzeichnet, dass** die Kammer eine Vielzahl von porösen, dreidimensional geformten Substraten umfasst, die sich hauptsächlich in einer Längsrichtung erstrecken, wobei die Substrate in einer Ladevorrichtung (75) gemäß einem der Ansprüche 3, 5 und 6 angeordnet sind, wobei die Gasversorgungsöffnungen der Vorrichtung durch das Reaktivgaseintrittsrohr der Kammer mit Reaktivgas versorgt werden.

8. Anlage zur Verdichtung dreidimensionaler poröser Substrate, die sich hauptsächlich in Längsrichtung erstrecken, mittels chemischer Infiltration in der Dampfphase, umfassend eine Reaktionskammer (80), eine Vielzahl von Reaktivgaseintrittsrohren (81), die an einem ersten Ende der Kammer angeordnet ist, und mindestens ein Auslassrohr (82), das sich in der Nähe eines zweiten Endes der Kammer gegenüber dem ersten befindet,
**dadurch gekennzeichnet, dass** die Kammer eine Vielzahl von porösen, dreidimensional geformten Substraten umfasst, die sich hauptsächlich in einer Längsrichtung erstrecken, wobei die Substrate in mindestens einer Ladevorrichtung (85) gemäß Anspruch 5 oder 6 angeordnet sind, wobei die Gasversorgungsöffnung(en) jeder Vorrichtung durch die Reaktivgaseintrittsrohre (81) der Kammer mit Reaktivgas versorgt wird (werden).

9. Anlage gemäß Anspruch 8, **dadurch gekennzeichnet, dass** die Kammer eine Vielzahl von Ladevorrichtungen (91, 92, 93) mit abnehmendem Durchmesser aufweist, die übereinander gestapelt sind.

10. Anlage gemäß Anspruch 8 oder 9, **dadurch gekennzeichnet, dass** die Kammer eine Vielzahl von Ladevorrichtungen (801, 802, 803, 804) desselben Durchmessers aufweist, die übereinander gestapelt sind.

## Claims

1. A loader device (10) for loading porous substrates (20) of three-dimensional shapes extending mainly in a longitudinal direction into a reaction chamber of an infiltration oven for densification of the preforms by directed flow chemical vapor infiltration, the device being **characterized in that** it comprises:
at least one annular loader stage (11) formed by first and second annular vertical walls (110, 111) arranged coaxially relative to each other and defining between them an annular loader space (13) for the porous substrates to be densified;
first and second plates (112, 113) respectively covering the bottom portion and the top portion of the annular loader space (13);
each of the first and second annular vertical walls (110, 111) including support elements (1100, 1110) arranged in the annular loader space (13), the support elements of the first and second annular vertical walls being in radial alignment so as to define between them unit loader cells (14) each for receiving a respective substrate to be densified; and
the device also including at least one gas feed orifice (1102) and at least one gas exhaust orifice (1112) in the vicinity of each unit loader cell.

2. A device according to claim 1, **characterized in that** the first annular vertical wall (110) of each loader stage (11) includes at least one gas feed orifice (1102) in the vicinity of each unit loader cell (14), and **in that** the second annular vertical wall (111) of each loader stage includes at least one gas exhaust orifice (1112) in the vicinity of each unit loader cell (14).

3. A device according to claim 2, **characterized in that** it comprises a plurality of annular loader stages (210, 220, 230, 240, 250) stacked on one another and arranged between the first and second plates (270, 271).

4. A device according to claim 1, **characterized in that** the first plate (313) has gas feed orifices (3132) in register with each unit loader cell (34), and **in that** the second plate (312) has gas exhaust orifices (3120) in register with each unit loader cell (34).

5. A device according to claim 4, **characterized in that** it comprises a plurality of annular loader stages (410, 420, 430, 440, 450) stacked on one another and arranged between the first and second plates (470, 472).

6. A device according to claim 4 or claim 5, **characterized in that** it further includes a plurality of annular loader stages (510, 520, 530) of different radial dimensions, said stages being arranged coaxially relative to one another.

7. An installation for densifying porous substrates by chemical vapor infiltration, the porous substrates being of three-dimensional shape that extends mainly in a longitudinal direction, the installation comprising a reaction chamber (70), a reagent gas admission pipe (71) situated at a first end of the chamber, and an exhaust pipe (72) situated in the vicinity of a second end of the chamber remote from the first, the installation being **characterized in that** the chamber contains a plurality of porous substrates of three-dimensional shape extending mainly in a longitudinal direction, said substrates being arranged in a loader device (75) according to any one of claims 3, 5, and 6, the gas feed orifice(s) of said device being fed with reagent gas via the reagent gas admission pipe of the chamber.

8. An installation for densifying porous substrates by chemical vapor infiltration, the porous substrates being of three-dimensional shape that extends mainly in a longitudinal direction, the installation comprising a reaction chamber (80), a plurality of reagent gas admission pipes (81) situated at a first end of the chamber, and at least one exhaust pipe (82) situated in the vicinity of a second end of the chamber remote from the first, the installation being **characterized in that** the chamber contains a plurality of porous substrates of three-dimensional shape extending mainly in a longitudinal direction, said substrates being arranged in at least one loader device (85) according to claim 5 or claim 6, the gas feed orifice(s) of each device being fed with reagent gas via the reagent gas admission pipes (81) of the chamber.

9. An installation according to claim 8, **characterized in that** the chamber contains a plurality of loader devices (91, 92, 93) of decreasing diameter stacked on one another.

10. An installation according to claim 8 or claim 9, **characterized in that** the chamber contains a plurality of loader devices (801, 802, 803, 804) of the same diameter stacked on one another.
